# EUROPEAN PATENT APPLICATION

(11) **EP 4 761 040 A1**
(43) Date of publication of application: **17.06.2026**
(21) Application number: 24907698.5
(22) Date of filing: 27.09.2024
(51) Int. Cl.: H02J 7/00, H01M 10/42, G01R 31/387

(54) **BATTERY UNIT AND BATTERY SYSTEM COMPRISING SAME**

(30) Priority: 22.12.2023 KR 20230189925
(71) Applicant: LG Energy Solution, Ltd., Seoul 07335 (KR)
(72) Inventor: LEE, Sung Gun, Daejeon 34122 (KR)
(74) Representative: Plasseraud IP
(86) International application number: PCT/KR2024/014791
(87) International publication number: WO 2025/135413

(57) **Abstract**

A battery system according to an embodiment disclosed in this document includes a plurality of battery units; and an upper controller configured to perform wireless communication with a battery unit assigned as a master unit among the plurality of battery units, wherein each of the plurality of battery units is assigned as the master unit to communicate with the upper controller in different periods.

## Description

### Technical Field

### CROSS-REFERENCE TO RELATED APPLICATION

This application claims priority to and the benefit of Korean Patent Application No. 10-2023-0189925 filed in the Korean Intellectual Property Office on December 22, 2023, the entire contents of which are incorporated herein by reference.

### TECHNICAL FIELD

Embodiments disclosed herein relate to a battery unit and a battery system including the same.

### Background Art

Recently, research and development on secondary batteries have been actively conducted. Here, the secondary batteries refer to batteries that can be charged and discharged, and encompass both conventional Ni/Cd, Ni/MH, etc. batteries, and recent lithium-ion batteries. Among the secondary batteries, the lithium-ion batteries have advantages of having much higher energy density than the conventional Ni/Cd, Ni/MH, etc. batteries. Further, the lithium-ion batteries are used as power sources for mobile devices because they can be made small and lightweight. Recently, the lithium-ion batteries have attracted attention as the next-generation energy storage medium as their use has expanded to power sources for electric vehicles.

The secondary battery includes battery modules in which battery cells, i.e., the minimum units for storing energy, are connected to one another. To maximize longevity, the battery cells need to undergo cell balancing that reduce variations therebetween. The cell balancing is classified into passive cell balancing that dissipates the energy of a target battery cell, and active cell balancing that charges other battery cells with the energy of the target battery cell. Here, the passive cell balancing causes loss of heat and energy because the energy of other battery cells is dissipated based on the capacity of a reference cell.

### Disclosure

### Technical Problem

An aspect of embodiments disclosed in this document is to provide a battery unit, which communicates with an upper controller, and a battery system including the same.

The technical problems of embodiments disclosed in this document are not limited to the aforementioned technical problems, and other unmentioned technical problems will become apparent to those skilled in the art, to which the disclosure pertains, from the following descriptions.

### Technical Solution

According to an embodiment disclosed in this document, a battery system includes: a plurality of battery units; and an upper controller configured to perform wireless communication with a battery unit assigned as a master unit among the plurality of battery units, wherein each of the plurality of battery units is assigned as the master unit to communicate with the upper controller in different periods.

According to an embodiment, each of the plurality of battery units may include: a battery cell; a processor configured to calculate a state of charge (SoC) of the battery cell based on state data related to at least one of voltage, current and temperature of the battery cell; and a communication module configured to transmit the state data of the battery cell and data related to the SoC of the battery cell to an outside.

According to an embodiment, each of the plurality of battery units may transmit the state data and the data related to the SoC of the battery cell to the battery unit assigned as the master unit, and the processor included in the master unit may calculate the different periods respectively corresponding to the plurality of battery units based on the state data and the SoC of the battery cell received from each of the plurality of battery units.

According to an embodiment, the processor included in the master unit may be configured to: calculate an average SoC of the plurality of battery cells, the SoC of which are received from each of the plurality of battery units; and assign priority to each of the plurality of battery cells based on a difference between each SoC of the plurality of battery cells and the average SoC of the plurality of battery cells

According to an embodiment, the priorities may be assigned in descending order of the differences between the SoC of the plurality of battery cells and the average SoC of the plurality of battery cells, and the different periods may correspond to values obtained by multiplying a preset reference time period by the assigned priorities.

According to an embodiment, in a case where there are the battery units of which the differences are the same, the processor included in the master unit may calculate the priorities to be assigned to the battery units with the same difference by multiplying the differences respectively corresponding to the battery units by a random function.

According to an embodiment, the plurality of battery units may operate in the assigned periods to communicate with the upper controller, and in a case where another battery unit performs communication with the upper controller before reaching the assigned period, the battery unit may not operate as the master unit even though a preset period is reached.

According to an embodiment, the battery system may be in a standby mode.

According to an embodiment, the upper controller may correspond to a module battery management system (BMS) or a pack BMS.

### Advantageous Effects

A battery unit according to an embodiment disclosed in this document is capable of communicating with the upper controller every preset period, and achieving a cell balancing effect based on power consumed in communicating with the upper controller.

The effects of an embodiment disclosed in this document are not limited to the aforementioned effects, and other unmentioned effects will become apparent to those skilled in the art from the disclosure of this document.

### Description of Drawings

FIG. 1 is a diagram for describing a battery system according to an embodiment disclosed in this document.
FIG. 2 is a diagram for describing a battery unit according to an embodiment disclosed in this document.
FIGS. 3A and 3B are diagrams for describing a process of identifying priorities assigned to battery units according to an embodiment disclosed in this document.
FIGS. 4A and 4B are diagrams for describing periods assigned to battery units according to an embodiment disclosed in this document.
FIG. 5 is a diagram for describing operations of a battery system according to an embodiment disclosed in this document.

### Mode for Invention

Hereinafter, embodiments disclosed in this document will be described in detail with reference to illustrative drawings. It should be noted that, in designating elements with reference numerals in drawings, the same elements will be designated with the same reference numerals as much as possible even though they are shown in different drawings. Further, in describing the embodiments disclosed in this document, detailed descriptions of publicly known configurations or functions incorporated herein will be omitted if it is determined that they interfere with the understanding of the embodiments disclosed in this document.

In describing elements of the embodiments disclosed in this document, terms, such as first, second, A, B, (a), and (b) may be used herein. Each of these terminologies is not used to define an essence, order or sequence of a corresponding component but used merely to distinguish the corresponding component from other component(s). Further, unless otherwise defined herein, all terms used herein including technical or scientific terms have the same meanings as those generally understood by those skilled in the art to which the embodiments disclosed in this document pertains. Terms defined in dictionaries generally used should be construed to have meanings matching with contextual meanings in the related art and are not to be construed as an ideal or excessively formal meaning unless explicitly defined herein.

Heretofore, even though all components configuring the embodiments of the disclosure are described to be combined as one unit or to operate as a combination thereof, the disclosure is not limited to these embodiments. Without departing from the scope of the disclosure, all components may be selectively combined to one or more thereof to operate as a combination. Also, the term "comprise," "include" or "have" specifies the presence of stated components unless specifically stated to the contrary, and should be construed to further include other components rather than precluding the presence thereof.

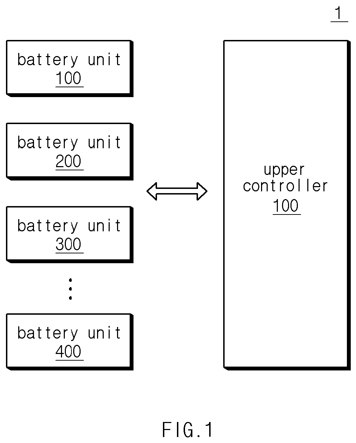

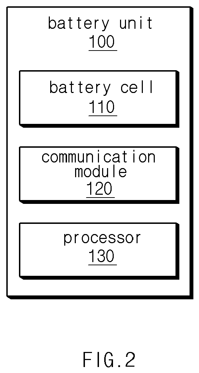

FIG. 1 is a diagram for describing a battery system according to an embodiment disclosed in this document, and FIG. 2 is a diagram for describing a battery unit according to an embodiment disclosed in this document.

First, referring to FIG. 1, a battery system 1 may include a plurality of battery units 100, 200, 300 and 400, and an upper controller 10.

The plurality of battery units 100, 200, 300 and 400 may refer to units of a battery, which can operate independently. Here, each of the plurality of battery units 100, 200, 300 and 400 may be configured to communicate with the plurality of other battery units 100, 200, 300 and 400 and/or the upper controller 10. FIG. 1 illustrates that the battery system 1 includes four battery units 100, 200, 300 and 400, but the battery system 1 is not limited to this example. The battery system 1 may include *n* battery units (where, *n* is an integer greater than or equal to 2).

Referring to FIG. 2, the configuration of the battery unit 100 is shown. According to an embodiment, the battery unit 100 may include a battery cell 110, a communication module 120, and a processor 130.

The battery cell 110 may be, but not limited to, a lithium ion (Li-ion) battery, a Li-ion polymer battery, a nickel-cadmium (Ni-Cd) battery, a nickel-hydrogen (Ni-MH) battery, etc. Meanwhile, the battery unit 100 according to this embodiment is shown as including one battery cell 110, but may include a plurality of battery cells according to an alternative embodiment.

The battery unit 100 may include the processor 120. The processor 120 may be configured to control the overall operations of the battery unit 100. The processor 120 may manage and/or control the states and/or operations of the battery cell 110. For example, the processor 120 may be configured to monitor the states of the battery cell 110, such as at least one of the voltage, current and temperature of the battery cell 110.

According to an embodiment, the processor 120 may directly acquire state data related to at least one of the voltage, current and temperature of the battery cell 110. In this case, various measurement circuits and/or sensors (not shown in FIG. 2) may be provided in the battery unit 100. Alternatively, the processor 120 may indirectly acquire state data related to at least one of the voltage, current and temperature of the battery cell 110.

The processor 120 may calculate the state of charge (SoC) of the battery cell 110 based on the state data of the battery cell 110. Furthermore, the processor 120 may calculate cell balancing time based on the calculated SoC of the battery cell 110, the capacity of the battery cell, etc. Here, the cell balancing time may be defined as time taken in the cell balancing for the battery cell 110.

The battery unit 130 may include the communication module 130 to communicate with the outside. The battery unit 100 may communicate with other battery units 200, 300 and 400 and/or the upper controller 10 shown in FIG. 1. According to an embodiment, the plurality of battery units 100, 200, 300 and 400 and the upper controller 10 may perform near field communication (NFC) with each other. In this case, the communication module 130 may include various NFC communication modules, but is not limited to this example.

In other words, the battery unit 100 may communicate with other battery units, for example, the battery units 200, 300 and 400 shown in FIG. 1 and/or the upper controller 10 through the communication module 120. Here, the battery unit 100 may transmit the state data of the battery cell 110, which is related to at least one of the voltage, current and temperature of the battery cell 110, and/or the data related to the SoC of the battery cell 110, which is calculated based on the state data of the battery cell 110, to the battery units 200, 300 and 400 and/or the upper controller 10.

Referring back to FIG. 1, the plurality of battery units 100, 200, 300 and 400 may constitute one battery module (not shown) and/or battery pack (not shown). In this case, the upper controller 10 may correspond to a module battery management system (BMS) and/or a pack BMS, but is not limited to this example. In other words, according to an embodiment disclosed in this document, the processor 130 (see FIG. 2) may be assigned to each battery cell 110 (see FIG. 2), and communicate with the upper controller 10, i.e., the module BMS and /or pack BMS.

According to an embodiment, any one of the plurality of battery units 100, 200, 300 and 400 may communicate with the upper controller 10. In this case, the battery unit communicating with the upper controller 10 may serve as a master unit, and the battery units excluding the master unit among the plurality of battery units 100, 200, 300 and 400 may serve as slave units. Below, for convenience of description, the description will be made assuming that the battery unit 100 shown in FIG. 2 is the master unit, but the description is not limited to this assumption.

According to an embodiment, the master unit 100 may communicate with the upper controller 10 and/or the slave units 200, 300, and 400. Here, the slave units 200, 300, and 400 may send the master unit 100 the state data related to at least one of the voltage, current and temperature of the battery cells (not shown) each included therein and the data related to the SoC of the battery cells (not shown) calculated based on the state data. Here, the slave units 200, 300 and 400 and the master unit 100 may perform the communication based on the NFC.

According to an embodiment, the master unit 100 may send the upper controller 10 the state data of the battery cells (not shown) respectively included in the plurality of battery units 100, 200, 300 and 400 and the SoC of the plurality of battery cells (not shown) calculated based on the state data. The upper controller 10 may manage and/or control the state of the plurality of battery units 100, 200, 300 and 400 based on the state data transmitted by the master unit 100 and/or the SoC of the battery cells (not shown).

In this case, only the master unit 100 continuously performs the communication with the upper controller 10, and thus the battery cell 110 (see FIG. 2) included in the master unit 100 may consume relatively more power than other battery cells (not shown) included in the slave units 200, 300 and 400. Therefore, when the master unit 100 communicating with the upper controller 10 is replaced by one of the other battery units 200, 300 and 400, it can make the effect of the passive cell balancing as the energy of the battery cell to be subjected to the cell balancing, i.e., the battery cell included in the new master unit is dissipated while communicating with the upper controller 10.

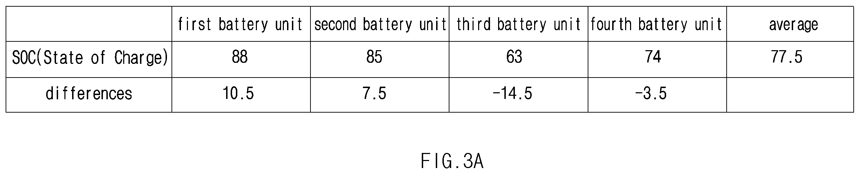

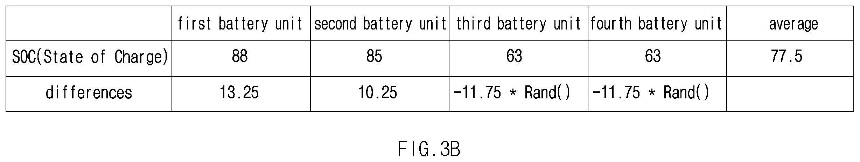

According to an embodiment, the processor 130 (see FIG. 2) included in the master unit 100 may identify another master unit, which will communicate with the upper controller 10, based on the state data of the battery cells respectively transmitted by the slave units 200, 300 and 400 and the SoC of the battery cells (not shown) calculated based on the state data. The processor 130 may calculate an average SoC of the battery cells (not shown) respectively included in the master unit 100 and the slave units 200, 300 and 400, and identify another master unit based on a difference between the SoC of the battery cells (not shown) and the average SoC. In this regard, details will be described later with reference to FIGS. 3A and 3B.

According to an embodiment, when the battery system 1 is in a standby mode (e.g., a sleep mode), the upper controller 10 may periodically communicate with the master unit 100. Here, the master unit 100 may assign priority to each of the slave units 200, 300 and 400 before the battery system 1 enters the standby state.

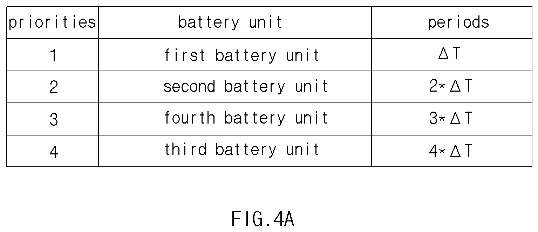

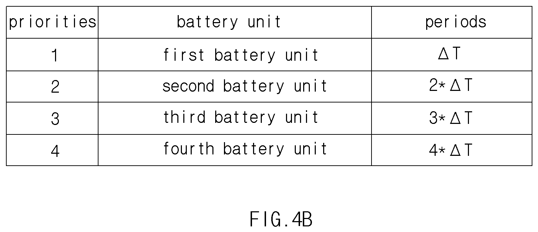

According to an embodiment, the priority assigned to each of the slave units 200, 300 and 400 may be related to a period in which each of the slave units 200, 300 and 400 is assigned as the master unit when the battery system 1 is in the standby mode. In this regard, details will be described later with reference to FIGS. 4A and 4B

FIGS. 3A and 3B are diagrams for describing a process of identifying priorities assigned to battery units according to an embodiment disclosed in this document, and FIGS. 4A and 4B are diagrams for describing periods assigned to battery units according to an embodiment disclosed in this document.

Before the battery system 1 (see FIG. 1) enters the standby mode, the master unit 100 (see FIG. 1) may assign the priority to each of the plurality of battery units 100, 200, 300 and 400, based on the state data of the battery cells respectively transmitted by the slave units 200, 300 and 400 (see FIG. 1) and the data related to the SoC of the battery cells (not shown) calculated based on the state data.

According to an embodiment, the processor 130 (see FIG. 2) included in the master unit 100 may calculate the average SoC of the battery cells respectively included in the plurality of battery units 100, 200, 300 and 400, based on the data related to each SoC of the battery cells.

Referring to FIG. 3A, the SoC of the battery cell included in the first battery unit 100 is 88%, the SoC of the battery cell included in the second battery unit 200 (see FIG. 1) is 85%, and the SoC of the battery cell included in the third battery unit 300 (see FIG. 1) is 63%, and the SoC of the battery cell included in the fourth battery unit 400 (see FIG. 1) is 74%.

According to an embodiment, the processor 130 included in the first battery unit 100, i.e., the master unit calculates the average SoC of the battery cells respectively included in the plurality of battery units 100, 200, 300 and 400. Here, the average SoC is 77.5%.

According to an embodiment, the processor 130 included in the first battery unit 100 may calculate a difference between the SoC of the battery cell included in each battery unit and the average SoC. The SoC of the battery cell included in the first battery unit 100 is 88%, and thus the difference corresponding to the first battery unit 100 is 10.5%, which is 88% minus 77.5%. Likewise, the SoC of the battery cell included in the second battery unit 200 is 85%, and thus the difference corresponding to the second battery unit 200 is 7.5%, which is 85% minus 77.5%. The SoC of the battery cell included in the third battery unit 300 is 63%, and thus the difference corresponding to the third battery unit 300 is -14.5%, which is 63% minus 77.5%. The SoC of the battery cell included in the fourth battery unit 400 is 74%, and thus the difference corresponding to the fourth battery unit 400 is -3.5%, which is 74% minus 77.5%.

According to an embodiment, the processor 130 may assign the priority to each of the plurality of battery units 100, 200, 300 and 400, based on the difference between the SoC of the battery cell included in each of the battery units and the average SoC. Here, the priority may be defined in descending order of the calculated differences. Referring to FIG. 4A, the first battery unit 100, i.e., the battery unit having the largest difference is ranked first, the second battery unit 200, i.e., the battery unit having the second largest difference is ranked second, the fourth battery unit 400, i.e., the battery unit having the third largest difference is ranked third, and the third battery unit 300, i.e., the battery unit having the smallest difference is ranked fourth.

According to an embodiment, each of the plurality of battery units 100, 200, 300, and 400 may be assigned as the master unit in each different period based on the assigned priority. Here, a preset period may be defined as a value obtained by multiplying the assigned priority by a preset reference time period ΔT. In other words, the first battery unit 100 ranked first may be configured to communicate with the upper controller 10 (see FIG. 1) in each first period (ΔT) obtained by multiplying the reference time period (ΔT) by a priority of '1,' the second battery unit 200 ranked second may be configured to communicate with the upper controller 10 in each second period (2*ΔT) obtained by multiplying the reference time period (ΔT) by a priority of '2,' the fourth battery unit 400 ranked third may be configured to communicate with the upper controller 10 in each third period (3*ΔT) obtained by multiplying the reference time period (ΔT) by a priority of '3,' and the third battery unit 300 ranked fourth may be configured to communicate with the upper controller 10 in each fourth period (4*ΔT) obtained by multiplying the reference time period (ΔT) by a priority of '4.' Here, the preset reference time period ΔT may be variously set and changed according to design, and is not limited to the specific example.

According to an embodiment, when the battery system 1 enters the standby mode, the battery system 1 may not monitor each state of the plurality of battery units 100, 200, 300 and 400 in real time to minimize power consumption. However, even in the standby mode, the upper controller 10 (see FIG. 1) is required to check each state of the plurality of battery units 100, 200, 300 and 400. Therefore, the plurality of battery units 100, 200, 300 and 400 perform the communication with the upper controller 10 in different periods, thereby transmitting their own states to the upper controller 10 even when the master unit is unable to communicate with the upper controller 10.

The table in FIG. 3B shows that there are battery units of which the differences between the SoC of the battery cells thereof and the average SoC are the same. The SoC of the battery cell included in the first battery unit 100 is 88%, the SoC of the battery cell included in the second battery unit 200 is 85%, and the SoC of the battery included in the third battery unit 300 is 63%, and the SoC of the battery cell included in the fourth battery unit 400 is 63%.

According to an embodiment, the processor 130 included in the first battery unit 100, i.e., the master unit may calculate the average SoC of the battery cells included in the plurality of battery units 100, 200, 300 and 400. Here, the average SoC is 74.75%.

According to an embodiment, the processor 130 included in the first battery unit 100 may calculate the difference between the SoC of the battery cell included in each battery unit and the average SoC. The SoC of the battery cell included in the first battery unit 100 is 88%, and thus the difference corresponding to the first battery unit 100 is 13.25%, which is 88% minus 74.75%. Likewise, the SoC of the battery cell included in the second battery unit 200 is 85%, and thus the difference corresponding to the second battery unit 200 is 10.25%, which is 85% minus 74.75%. Each SoC of the battery cells included in the third and fourth battery units 300 and 400 is 63%, and thus each difference corresponding to the third and fourth battery units 300 and 400 is -11.75%, which is 63% minus 74.75%.

Here, the differences corresponding to the third and fourth battery units 300 and 400 are the same at -11.75%, and thus the processor 130 may prioritize the third and fourth battery units 300 and 400 by multiplying the differences respectively corresponding to the third and fourth battery units 300 and 400 by a random function (Rand()). Here, the random function (Rand()) may be defined as a function having a random value between '0' and '1.'

Referring back to FIG. 4B, the processor 130 may assign the priority to each of the plurality of battery units 100, 200, 300 and 400, based on the difference between the SoC of the battery cell included in each of the battery units and the average SoC. Here, the priority may be defined in descending order of the calculated differences. Referring to FIG. 4B, the first battery unit 100, i.e., the battery unit having the largest difference is ranked first, the second battery unit 200, i.e., the battery unit having the second largest difference is ranked second, the third battery unit 300, i.e., the battery unit having the third largest difference is ranked third, and the fourth battery unit 300, i.e., the battery unit having the smallest difference is ranked fourth.

Further, each of the first to fourth battery units 100 to 400 may be assigned as the master unit to communicate with the upper controller 10 in each different period. For convenience of description, repetitive descriptions will be omitted.

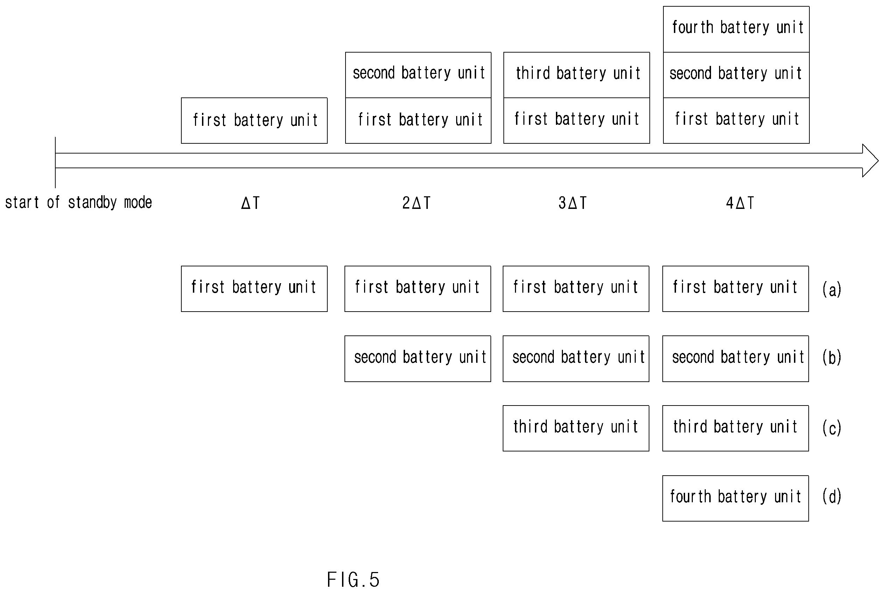

FIG. 5 is a diagram for describing operations of a battery system according to an embodiment disclosed in this document.

According to an embodiment, the battery system 1 (see FIG. 1) may enter the standby mode. In the standby mode, the battery system 1 may not monitor each state of the plurality of battery units 100, 200, 300 and 400 in real time to minimize power consumption. However, even in the standby mode, the upper controller 10 (see FIG. 1) is required to check each state of the plurality of battery units 100, 200, 300 and 400. Therefore, the plurality of battery units 100, 200, 300 and 400 perform the communication with the upper controller 10 in different periods, thereby transmitting their own states to the upper controller 10 even when the master unit 100 is unable to communicate with the upper controller 10.

Hereinafter, for convenience of description, the description will be made on the assumption that the plurality of battery units 100, 200, 300 and 400 are prioritized as shown in FIG. 4B, but the description is not limited to this assumption.

According to an embodiment, the first battery unit 100 ranked first may be assigned as the master unit to communicate with the upper controller 10 in each first period (ΔT), the second battery unit 200 ranked second may be assigned as the master unit to communicate with the upper controller 10 in each second period (2*ΔT), the third battery unit 300 ranked third may be assigned as the master unit to communicate with the upper controller 10 in each third period (3*ΔT), and the fourth battery unit 400 ranked fourth may be assigned as the master unit to communicate with the upper controller 10 in each fourth period (4*ΔT).

According to an embodiment, when another battery unit performs the communication with the upper controller 10 before reaching the assigned preset period, that battery unit may not operate as the master unit even though the preset period is reached.

For example, the first battery unit 100 may be assigned as the master unit to communicate with the upper controller 10 at a point in time when the first period ΔT has passed after the battery system 1 enters the standby mode (a). In this case, the first battery unit 100 may transmit the state data related to at least one of the voltage, current, and temperatures of the battery cell included in each of the first to fourth battery units 100, 200, 300, and 400 to the upper controller 10. Then, the first battery unit 100 may serve as the master unit to communicate with the upper controller 10 at a point in time when the first period (ΔT) has passed once more, that is, when the second period (2*ΔT) has passed after the battery system 1 enters the standby mode. Because the first battery unit 100 was assigned as the master unit to communicate with the upper controller 10 at a point in time when the first period (ΔT) has passed after the battery system 1 enters the standby mode, the second battery unit 200 may not operate as the master unit at a point in time when the second period (2*ΔT) has passed after the battery system 1 enters the standby mode. Likewise, the third battery unit 300 may not operate as the master unit at a point in time when the third period (3*ΔT) has passed after the battery system 1 enters the standby mode, and the fourth battery unit 400 may not operate as the master unit at a point in time when the fourth period (4*ΔT) has passed after the battery system 1 enters the standby mode.

For another example, the first battery unit 100 may be assigned as the master unit 100 at the time point after the first period ΔT has passed after the battery system 1 enters the standby mode. However, due to various reasons, there may occur a situation in which the communication with the upper controller 10 may not be performed at a point in time when the first period (ΔT) has passed after the first battery unit 100 enters the standby mode. In this case, the second battery unit 200 may be assigned as the master unit 200 at a point in time when the second period (2*ΔT) has passed after the battery system 1 enters the standby mode. Because the first battery unit 100 did not communicate with the upper controller 10 at a point in time when the first period (ΔT) has passed after the battery system 1 enters the standby mode, the second battery unit 200 assigned as the master unit 200 may communicate with the upper controller 10 at a point in time when the second period (2*ΔT) has passed after the battery system 1 enters the standby mode.

For another example, in the case where the first battery unit 100 and the second battery unit 200 did not perform the communication with the upper controller 10 at a point in time when the third cycle (3*ΔT) has passed after the battery system 1 enters the standby mode, the third battery unit 300 may be assigned as the master unit to communicate with the upper controller 10 at a point in time when the third cycle (3*ΔT) has passed after entering the standby mode.

For another example, in the case where the first battery unit 100, the second battery unit 200, and the third battery unit 300 did not perform the communication with the upper controller 10 at a point in time when the fourth cycle (4*ΔT) has passed after the battery system 1 enters the standby mode, the fourth battery unit 400 may be assigned as the master unit to communicate with the upper controller 10 at a point in time when the fourth cycle (4*ΔT) has passed after entering the standby mode.

The battery system 1 according to an embodiment disclosed in this document prioritizes the plurality of battery units 100, 200, 300 and 400 before entering the standby mode, thereby allowing the plurality of battery units to communicate with the upper controller 10 even though the master unit is unable to perform the communication. In this way, the battery system 1 may configure the upper controller 10 to manage and control the plurality of battery units 100, 200, 300 and 400 even in the standby mode while consuming the minimum power, and make an effect similar to that of performing the cell balancing through the power consumed while the master unit communicates with the upper controller 10.

The foregoing description is merely an illustrative description of the technical ideas disclosed in this document, and various modifications and changes can be made by a person having ordinary knowledge in the art, to which the embodiments disclosed in this document pertains, without departing from the essential characteristics of the embodiments disclosed in this document.

Accordingly, the embodiments disclosed in this document are intended not to limit but describe the technical ideas disclosed in this document, and the scope of the technical ideas disclosed in this document is not limited by these embodiments. The scope of the technical ideas disclosed in this document should be interpreted by claims appended below, and all technical ideas within the equivalent scope should be construed as falling within the scope of this document.

### [Reference Numerals]

1: battery system
100, 200, 300, 400: battery unit
110: battery cell
120: communication module
130: controller

## Claims

1. A battery system comprising:
a plurality of battery units; and
an upper controller configured to perform wireless communication with a battery unit assigned as a master unit among the plurality of battery units,
wherein each of the plurality of battery units is assigned as the master unit to communicate with the upper controller in different periods.

2. The battery system of claim 1, wherein
each of the plurality of battery units comprises:
a battery cell;
a processor configured to calculate a state of charge (SoC) of the battery cell based on state data related to at least one of voltage, current and temperature of the battery cell; and
a communication module configured to transmit the state data of the battery cell and data related to the SoC of the battery cell to an outside.

3. The battery system of claim 2, wherein
each of the plurality of battery units transmits the state data and the data related to the SoC of the battery cell to the battery unit assigned as the master unit, and
the processor included in the master unit calculates the different periods respectively corresponding to the plurality of battery units based on the state data and the SoC of the battery cell received from each of the plurality of battery units.

4. The battery system of claim 3, wherein
the processor included in the master unit is configured to:
calculate an average SoC of the plurality of battery cells, the SoC of which are received from each of the plurality of battery units; and
assign priority to each of the plurality of battery cells based on a difference between each SoC of the plurality of battery cells and the average SoC of the plurality of battery cells.

5. The battery system of claim 4, wherein
the priorities are assigned in descending order of the differences between the SoC of the plurality of battery cells and the average SoC of the plurality of battery cells, and
the different periods correspond to values obtained by multiplying a preset reference time period by the assigned priorities.

6. The battery system of claim 5, wherein, in a case where there are the battery units of which the differences are the same, the processor included in the master unit calculates the priorities to be assigned to the battery units with the same difference by multiplying the differences respectively corresponding to the battery units by a random function.

7. The battery system of claim 6, wherein
the plurality of battery units operates in the assigned periods to communicate with the upper controller, and
in a case where another battery unit performs communication with the upper controller before reaching the assigned period, the battery unit does not operate as the master unit even though a preset period is reached.

8. The battery system of claim 1, wherein the battery system is in a standby mode.

9. The battery system of claim 1, wherein the upper controller corresponds to a module battery management system (BMS) or a pack BMS.
